# DEMANDE DE BREVET EUROPEEN

(11) **EP 4 765 524 A1**
(43) Date de publication de la demande: **24.06.2026**
(21) Numéro de dépôt: 25222457.1
(22) Date de dépôt: 11.12.2025
(51) Int. Cl.: H01S 5/042

(54) **PROCÉDÉ DE FABRICATION D'UN DISPOSITIF ÉLECTRONIQUE**

(30) Priorité: 18.12.2024 FR 2414543
(71) Demandeur: Commissariat à l'Energie Atomique et aux Energies Alternatives, 75015 Paris (FR)
(72) Inventeur: BARBET, Sophie, 38054 Grenoble cedex 09 (FR); THIBON, Romain, 38054 Grenoble cedex 09 (FR)
(74) Mandataire: Germain Maureau

(57) **Abrégé**

Le procédé de fabrication permet de fabriquer un dispositif (100) électronique comprenant : un substrat (101) ; un composant (102) électronique formé à partir du substrat (101) ; une couche (103) de planarisation en résine et agencée sur le composant (102) électronique ; un élément (108a, 108b, 108c) électriquement conducteur traversant la couche (103) de planarisation, ledit élément (108a, 108b, 108c) électriquement conducteur étant en contact avec une partie (106a, 106b, 106c) du composant (102) électronique et présentant une surface (109a, 109b, 109c) de contact agencée du côté d'une face (110) de la couche (103) de planarisation opposée au substrat (101).

## Description

### Domaine technique de l'invention

Le domaine technique de l'invention concerne l'électronique et plus particulièrement la microélectronique. L'invention est relative à un procédé de fabrication d'un dispositif électronique comprenant un composant électronique et une couche de planarisation, notamment formée au contact du composant électronique. Le composant électronique est préférentiellement un laser.

### Etat de la technique antérieure

Dans le domaine de la microélectronique, il est connu de former un composant électronique sur un substrat en vue de former un dispositif électronique tel qu'une puce, aussi appelée puce électronique. Une fois le composant électronique terminé, certaines structures de dispositif électronique nécessitent de prévoir au sein du dispositif électronique une couche de planarisation recouvrant au moins partiellement le composant électronique. Le but de cette couche de planarisation est d'assurer que la topographie du composant électronique ne soit pas une entrave à la reprise de contact local, ou de permettre de connecter deux puces entre elles par exemple par report de l'une sur l'autre aussi connu sous la terminologie anglaise « flip-chip ».

Ainsi, classiquement la couche de planarisation peut être ouverte localement jusqu'au composant électronique en vue de former, à partir d'un trou traversant résultant de cette ouverture, un via (aussi appelé trou métallisé) reliant électriquement le composant électronique de sorte à ce que le via présente une surface de contact du côté de la couche de planarisation opposé au substrat.

A cet effet, après avoir déposé la couche de planarisation, il est commun de former, sur cette couche de planarisation, une couche de résine photosensible, puis d'insoler cette dernière avant de réaliser un développement rendant accessible une ou des portions de la face de la couche de planarisation à l'opposé du substrat. Ensuite, la couche de planarisation est gravée par gravure sèche localement au niveau des portions avec arrêt sélectif de la gravure sèche sur le composant électronique. Après la gravure sèche, le reste de la couche de résine photosensible est retiré afin de permettre la mise en œuvre d'un dépôt de métal aux endroits où la couche de planarisation a été gravée pour permettre une reprise de contact (formation de vias) sur le composant électronique de sorte que le métal déposé soit accessible du côté de la face de la couche de planarisation opposée au substrat.

Toutes ces étapes ont un coût lors de la fabrication du dispositif électronique, ce coût étant majoré lorsque les gravures doivent s'arrêter sur des matériaux différents du composant électronique et/ou à des niveaux différents au-dessus du substrat.

A titre d'exemple, il est donné un procédé classique de fabrication d'un dispositif électronique dont le composant électronique est un laser sur substrat de silicium.

Le procédé de fabrication comprend une étape de formation du laser comprenant une base en InP dopé N agencée sur le substrat et surmontée localement d'une couche quantique destinée à former une cavité Fabry-Pérot du laser. Cette couche quantique est surmontée d'une couche en InP dopé P destinée à former une partie du laser. L'étape de formation du laser comprend la formation de premières bornes de connexion métalliques sur la base, et agencées à un même niveau au-dessus du substrat, et la formation d'une deuxième borne de connexion métallique sur la couche en InP dopé P. La composition des premières bornes de connexion métalliques est notamment différente, en terme de matériaux, de la composition de la deuxième borne métallique. Il en résulte que, outre l'utilisation de compositions différentes pour former les premières bornes de connexion et la deuxième borne de connexion, les premières bornes de connexion sont agencées à un premier niveau au-dessus du substrat inférieur à un deuxième niveau au-dessus du substrat où est agencée la deuxième borne de connexion.

Suite à l'étape de formation du laser, une couche de planarisation est formée sur le substrat et le laser, cette couche de planarisation comprenant du Benzo-Cyclo-Butène (aussi connu sous l'abréviation BCB).

Sur cette couche de planarisation, la reprise des premières bornes de connexion et de la deuxième borne de connexion se font en deux temps.

Dans un premier temps, il est déposé une résine photosensible positive qui est insolée puis développée pour former un premier masque de gravure en vue de former un accès aux premières bornes de connexion au travers de la couche de planarisation. Une fois le premier masque de gravure formé, il est réalisé une gravure sèche à plasma à couplage inductif de la couche de planarisation avec arrêt sur le métal des premières bornes de connexion. Après cela, la résine photosensible est retirée.

Dans un second temps, il est déposé à nouveau une résine photosensible positive, venant notamment combler les accès aux premières bornes de connexion préalablement formés, qui est insolée puis développée pour former un deuxième masque de gravure en vue de former un accès à la deuxième borne de connexion au travers de la couche de planarisation. Une fois le deuxième masque de gravure formé, il est réalisé une gravure sèche à plasma à couplage inductif de la couche de planarisation avec arrêt sur le métal de la deuxième borne de connexion. Après cela, la résine photosensible est retirée.

Les gravures sèches ont permis de former des trous au travers de la couche de planarisation, ces trous présentant chacun un fond délimité respectivement par les premières bornes de connexion et la deuxième borne de connexion. Il reste à ce stade, pour chaque trou, à former une couche de métallisation couvrant son fond, des flancs dudit trou et une périphérie d'une ouverture du trou agencée à l'interface avec la face de la couche de planarisation opposée au substrat.

Un tel procédé présente différents inconvénients tels que :
- le BCB comprend un noyau aromatique reconnu comme étant cancérigène ;
- le BCB utilisé nécessite forcément une gravure sèche à plasma à couplage inductif pour accéder aux premières bornes de connexion et à la deuxième borne de connexion ;
- la gravure du BCB peut être destructive si elle n'est pas parfaitement adaptée à l'épaisseur de BCB à graver, c'est pour cela que l'ouverture du BCB pour accéder aux premières bornes de connexion et à la deuxième borne de connexion doit être faite en deux temps, et, par conséquent, deux photolithographies doivent être réalisées pour être adaptée à l'épaisseur de BCB à graver.
Cela induit de prendre en compte de nombreux paramètres et des précautions particulières lors de la fabrication du dispositif électronique.

### Objet de l'invention

La présente invention a pour but de remédier au moins en partie aux inconvénients précités.

A cet effet, l'invention est relative à un procédé de fabrication d'un dispositif électronique comprenant les étapes suivantes :
a) prévoir un substrat ;
b) former un composant électronique à partir du substrat ;
c) former une couche de planarisation en résine sur le composant électronique, ladite résine étant photosensible et électriquement isolante ;
d) réaliser une insolation de la couche de planarisation au travers d'un masque de photolithographie d'où il résulte une délimitation d'une région sacrificielle au sein de la couche de planarisation, ladite région sacrificielle étant en contact avec une partie du composant électronique et étant apte à être retirée par un développeur ;
e) réaliser un développement à l'aide du développeur afin de retirer ladite région sacrificielle d'où il résulte l'obtention d'un trou présentant un fond délimité au moins en partie par ladite partie du composant électronique ;
f) déposer un matériau électriquement conducteur pour obtenir un élément électriquement conducteur au niveau du trou, ledit élément électriquement conducteur étant en contact avec le fond du trou et avec une portion de la couche de planarisation destinée à être permanente au sein du dispositif électronique, ledit élément électriquement conducteur présentant une surface de contact agencée du côté d'une face de la couche de planarisation opposée au substrat.

L'utilisation d'une résine initialement photosensible qui reste à demeure, après son ouverture (formation du trou), au sein du dispositif électronique en tant que couche de planarisation permet avantageusement de limiter le nombre d'étapes du procédé. En outre, cela permet d'utiliser d'autres produits que le Benzo-Cyclo-Butène reconnu à ce jour comme cancérigène.

Le procédé de fabrication peut en outre comprendre une ou plusieurs des caractéristiques suivantes.

Selon une caractéristique du procédé de fabrication, le développeur est un produit inerte par rapport au composant électronique et préférentiellement/de préférence par rapport au substrat.

Cela permet d'éviter les risques de détérioration du dispositif électronique au cours de sa fabrication et cela facilite grandement la mise en œuvre du procédé de fabrication dans le sens où il y a moins de précautions à prendre que dans le cas d'une gravure sèche à plasma à couplage inductif.

Selon une caractéristique du procédé de fabrication, la résine comprend composé issu de la famille des siloxanes, comme par exemple un cyclopentanone, et le développeur est un alcool isopropylique.

L'utilisation de l'alcool isopropylique est avantageux dans le sens où il s'agit d'un solvant inerte par rapport au composant électronique et au substrat. L'utilisation d'une telle résine est avantageuse car, outre sa capacité à être photosensible, elle présente des caractéristiques optiques intéressantes pour former un dispositif électronique de type optoélectronique tel qu'un laser.

Selon une caractéristique du procédé de fabrication, l'étape c) est mise en œuvre par un dépôt à la tournette.

Un tel dépôt permet de contrôler l'épaisseur de la couche de planarisation tout en assurant la formation d'une surface plane à l'opposé du substrat.

Selon une caractéristique du procédé de fabrication, l'étape e) est telle que le fond du trou est relié à une ouverture du trou par au moins un flanc sortant du trou.

Cela permet une bonne qualité de la métallisation formant l'élément électriquement conducteur, assurant ainsi une conductivité électrique idoine depuis le composant électronique jusqu'au niveau de la face de la couche de planarisation opposée au substrat.

Selon une caractéristique du procédé de fabrication, la partie du composant électronique délimitant au moins en partie le fond du trou est au moins en partie délimitée par une borne de connexion du composant électronique.

Il en résulte que l'élément électriquement conducteur permet une reprise de contact de la borne de connexion jusqu'au niveau de la face de la couche de planarisation opposée au substrat.

Selon une caractéristique du procédé de fabrication, le procédé de fabrication est tel que :
- l'étape d) est telle que le masque de photolithographie permet de former plusieurs régions sacrificielles au sein de la couche de planarisation, chacune des régions sacrificielles étant en contact avec une partie correspondante du composant électronique et étant apte à être retirée par le développeur ;
- l'étape e) est telle que les régions sacrificielles sont retirées toutes au moins en partie simultanément, les régions sacrificielles étant retirées de sorte à former une pluralité de trous présentant chacun un fond délimité au moins en partie par la partie correspondante du composant (102) électronique ;
- l'étape f) est telle que le dépôt de matériau (M1) électriquement conducteur est réalisé pour former des éléments électriquement conducteurs au niveau de chacun des trous.

Le procédé de fabrication est ainsi rationalisé car il est possible d'utiliser une même étape de développement pour former tous les trous destinés à former des connexions au composant électronique au travers de la couche de planarisation.

Selon une caractéristique du procédé de fabrication, le composant électronique formé à l'étape b) comprend des bornes de connexion, et chacune des parties correspondantes du composant électronique est formée au moins en partie par une surface d'une des bornes de connexion, au moins deux des bornes de connexion étant de compositions différentes et agencées à des hauteurs différentes par rapport au substrat.

Le procédé de fabrication permet ainsi de mutualiser les étapes quelles que soient les compostions des bornes de connexion et leur hauteur par rapport au substrat. Ceci est notamment rendu possible grâce à l'utilisation de la résine photosensible qui peut être rendu soluble par le développeur seulement aux endroits où elle a été insolée (cas de la résine dite positive) ou aux endroits où elle n'a pas été insolée (cas de la résine dite négative) et préférentiellement du fait de la propriété du développeur à être inerte par rapport au composant électronique.

Selon une caractéristique du procédé de fabrication, le composant électronique est un composant optoélectronique, de préférence un laser.

Ceci est notamment possible en choisissant une résine photosensible dont les caractéristiques optiques sont compatibles pour recouvrir le composant électronique.

L'invention est aussi relative à un dispositif électronique comprenant :
- un substrat ;
- un composant électronique formé à partir du substrat ;
- une couche de planarisation permanente issue d'une résine photosensible et agencée au contact du composant électronique ;
- un élément électriquement conducteur traversant la couche de planarisation, ledit élément électriquement conducteur étant en contact avec une partie du composant électronique et présentant une surface de contact agencée du côté d'une face de la couche de planarisation opposée au substrat.

Un tel dispositif électronique est avantageux dans le sens où sa couche de planarisation peut être formée en un matériau ne contenant pas de noyau aromatique au benzène. En outre, un tel dispositif électronique peut être obtenu à moindre coût dans le sens où la résine photosensible ou polymérisée reste présente au sein du dispositif électronique. Par ailleurs, le dispositif électronique final n'intégrant pas de couches d'arrêt spécifiques nécessaires en cas de technique de gravure pour savoir si toute l'épaisseur a bien été gravée, il présente une meilleure dissipation thermique.

Le dispositif électronique peut comprendre plusieurs éléments électriquement conducteurs chacun en contact avec une partie correspondante du composant électronique et présentant chacun une surface de contact agencée du côté de la face de la couche de planarisation opposée au substrat.

Cela permet d'autoriser plusieurs reprises de contact distinctes pour un même composant électronique du côté de la face de la couche de planarisation opposée au substrat.

Le dispositif électronique peut être tel que le composant électronique comprend des bornes de connexion et que chacune des parties correspondantes du composant électronique est formée au moins en partie par une surface d'une des bornes de connexion, au moins deux des bornes de connexion étant de compositions différentes et agencées à des hauteurs différentes par rapport au substrat.

Un tel dispositif électronique présente un avantage en terme de coût de fabrication dans le sens où il résulte de la présence de la couche de planarisation en résine que des étapes de lithographie et de gravure distinctes ne sont pas nécessaires tout comme la présence de couches d'arrêts spécifiques pour permettre l'accès à ces bornes de connexion situées sous la couche de planarisation avant l'étape e) du procédé de fabrication.

D'autres avantages et caractéristiques pourront ressortir de la description détaillée qui suit.

### Brève description des dessins

L'invention sera mieux comprise à la lecture de la description détaillée qui suit, donnée uniquement à titre d'exemple non limitatif et faite en se référant aux dessins annexés et listés ci-dessous.
La figure 1 représente schématiquement une vue en coupe d'un substrat prévu au cours d'un procédé de fabrication d'un dispositif électronique selon un mode de réalisation de l'invention.
La figure 2 représente schématiquement une vue en coupe montrant un composant électronique formé sur le substrat.
La figure 3 représente schématiquement une vue en coupe montrant le dépôt d'une couche de planarisation sur le composant électronique.
La figure 4 représente schématiquement une vue en coupe montrant une partie d'une étape de photolithographie réalisée sur l'ensemble montré en figure 3.
La figure 5 montre schématiquement une vue en coupe du résultat d'un développement au terme de l'étape de photolithographie.
La figure 6 montre, selon une vue schématique en coupe le dispositif électronique au terme du procédé de fabrication.

Sur ces figures, les mêmes références sont utilisées pour désigner les mêmes éléments. Les éléments représentés sur les différentes figures ne sont pas nécessairement réalisés à l'échelle afin de faciliter la compréhension des figures.

### Description détaillée

Dans la présente description, par « au-dessus » ou « sous », le référentiel à prendre en compte est celui des figures.

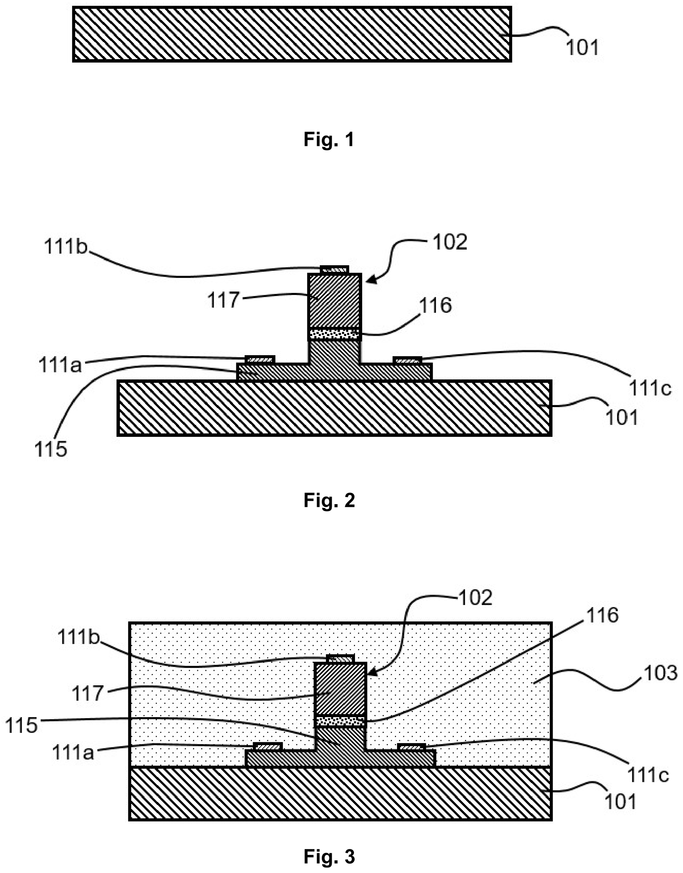

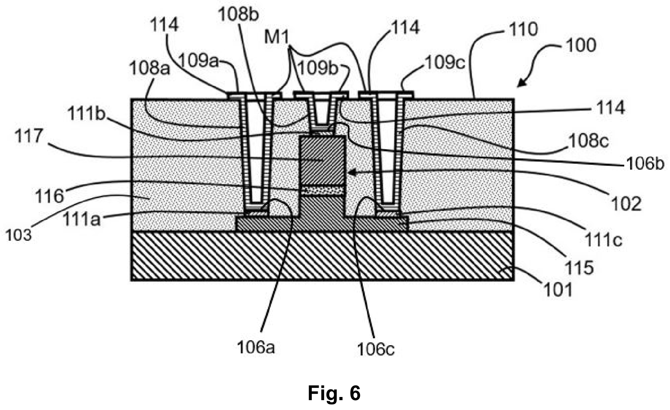

L'invention concerne un procédé de fabrication d'un dispositif 100 électronique dont différentes étapes sont illustrées à titre d'exemple en figures 1 à 6. Le dispositif 100 électronique est notamment visible en figure 6.

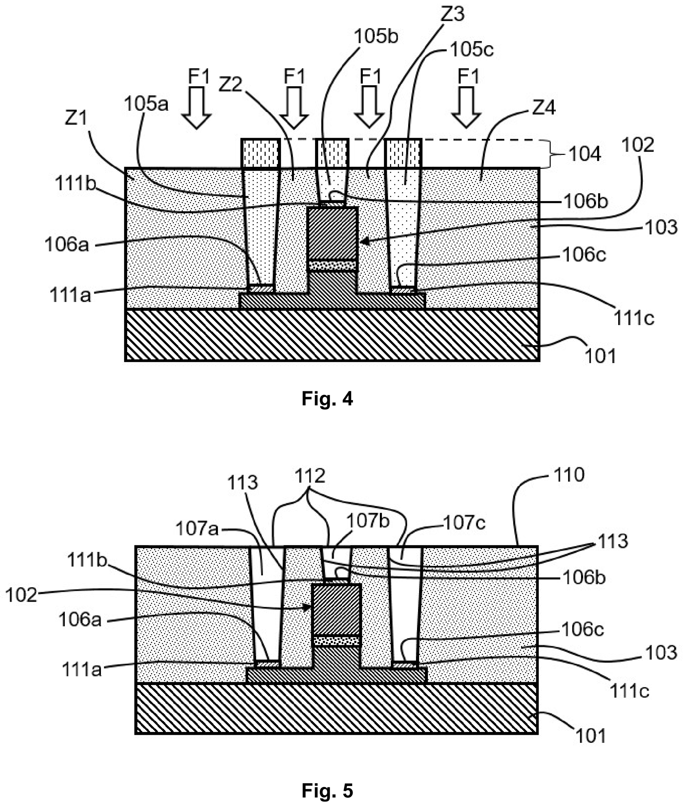

Le procédé de fabrication du dispositif 100 électronique comprend les étapes, notamment successives, suivantes :
a) prévoir un substrat 101 (figure 1) ;
b) former un composant 102 électronique à partir du substrat 101 (figure 2) ;
c) former une couche 103 de planarisation en résine sur le composant 102 électronique, ladite résine étant photosensible et électriquement isolante (figure 3) ;
d) réaliser une insolation (flèches F1) de la couche 103 de planarisation au travers d'un masque 104 de photolithographie d'où il résulte une délimitation d'une région 105a, 105b, 105c sacrificielle au sein de la couche 103 de planarisation, ladite région 105a, 105b, 105c sacrificielle étant en contact avec une partie 106a, 106b, 106c du composant 100 électronique et étant apte à être retirée par un développeur (figure 4) ;
e) réaliser un développement à l'aide du développeur afin de retirer ladite région 105a, 105b, 105c sacrificielle d'où il résulte l'obtention d'un trou 107a, 107b, 107c présentant/comprenant un fond délimité au moins en partie par ladite partie 106a, 106b, 106c du composant 102 électronique (figure 5) ;
f) déposer un matériau M1 électriquement conducteur pour obtenir un élément 108a, 108b, 108c électriquement conducteur au niveau du trou 107a, 107b, 107c, ledit élément 108a, 108b, 108c électriquement conducteur étant en contact avec le fond du trou 107a, 107b, 107c et notamment avec une portion de la couche 103 de planarisation destinée à être permanente au sein du dispositif 100 électronique, ledit élément 108a, 108b, 108c électriquement conducteur présentant/comprenant une surface 109a, 109b, 109c de contact agencée du côté d'une face 110 de la couche 103 de planarisation opposée au substrat 101 (figure 6).

Les étapes c), d) et e) forment ensemble une étape de photolithographie.

L'étape d) peut être mise en œuvre à l'aide d'un rayonnement, notamment dit « rayonnement électromagnétique », d'une longueur d'onde prédéterminée, par exemple à l'aide d'une lampe au mercure, adaptée pour participer à délimiter la région 105a, 105b, 105c sacrificielle du fait de l'insolation de la couche 103 de planarisation au travers du masque 104 de photolitograpie par ledit rayonnement.

L'étape f) permet notamment de former, au niveau du trou 107a, 107b, 107c, un trou d'interconnexion aussi appelé via ou trou métallisé dans le domaine.

En particulier, la surface 109a, 109b, 109c de contact, agencée du côté de la face 110 de la couche 103 de planarisation opposée au substrat 101, est résultante d'une portion de la couche déposée en matériau M1, cette portion étant déposée sur ladite face 110.

Il résulte du passage de la figure 4 à la figure 5 que la résine utilisée pour former la couche 103 de planarisation est une résine dite négative dans le sens où chaque zone exposée au rayonnement résiste au développement, c'est-à-dire que la région 105a, 105b, 105c sacrificielle est non-polymérisée et soluble dans le développeur (c'est par exemple en ce sens que des zones Z1, Z2, Z3, Z4 de la couche 103 de planarisation, non solubles dans le développeur, dont le motif a localement changé entre la figure 3 et la figure 4 sont identifiables en figure 4). Bien entendu, cela n'est pas limitatif dans le sens où la résine peut tout aussi bien être une résine positive : dans ce cas le masque 104 de photolithographie sera adapté et ne couvrira pas chaque zone à ouvrir, i.e. correspondant à la région 105a, 105b, 105c sacrificielle qui est alors une portion polymérisée de la résine utilisée pour former la couche 103 de planarisation.

Notamment, le masque 104 de photolithographie ne sert qu'à l'insolation et n'est pas permanent sur la surface de la couche 103 de planarisation.

Un avantage d'utiliser la couche 103 de planarisation en résine photosensible est d'éviter de mettre en œuvre une étape de gravure d'une couche planarisante nécessitant de prévoir un masque de gravure formé par exemple par photolithographie sur la couche planarisante à graver avec un arrêt de gravure spécifique à prévoir. En outre, cela permet d'utiliser d'autres matériaux que le Benzo-Cyclo-Butène reconnu comme cancérigène.

En fonction du type de dispositif 100 électronique, le substrat 100 peut être un substrat de silicium ou un substrat en matériau III-V, i.e. un matériau composé d'un ou de plusieurs éléments de la colonne III et de la colonne V du tableau périodique de Mendeleïev.

Par « composant 102 électronique » formé à partir du substrat 101, il est entendu que le « composant 102 électronique » peut être formé sur le substrat 101 qui forme alors un simple support ou être en partie intégré dans le substrat 101 dont une partie forme aussi une portion du composant 102 électronique.

L'étape c) est notamment réalisée de sorte que la couche 103 de planarisation recouvre le composant 102 électronique qui se retrouve alors sous la face 110 de la couche 103 de planarisation opposée au substrat.

Ainsi, l'invention est aussi relative au dispositif 100 électronique, notamment tel qu'obtenu par le procédé de fabrication, et par exemple visible en figure 6. Le dispositif 100 électronique comprend :
- le substrat 101 ;
- le composant 102 électronique formé à partir du substrat 101, et notamment agencé sur le substrat 101 ;
- la couche 103 de planarisation alors permanente (i.e. qui reste présente au sein du dispositif 100 électronique notamment tout au long de son utilisation) issue de la résine photosensible et agencée au contact du (i.e. agencée sur le) composant 102 électronique ;
- un élément 108a, 108b, 108c électriquement conducteur traversant la couche 103 de planarisation, ledit élément 108a, 108b, 108c électriquement conducteur étant en contact avec une partie 106a, 106b, 106c du composant 102 électronique et présentant/comprenant une surface 109a, 109b, 109c de contact (notamment tournée vers une direction opposée au substrat 101) agencée du côté de la face 110 de la couche 103 de planarisation opposé au substrat 101.

Par « la couche 103 de planarisation permanente issue d'une résine photosensible », il est entendu que la couche 103 de planarisation peut être, au sein du dispositif 100 électronique en résine photosensible (cas où la résine est positive) ou en résine insolée qui n'est plus photosensible (cas où la résine au sein du dispositif 100 électronique est en résine négative insolée - aussi appelée résine polymérisée - au cours du procédé de fabrication et donc plus photosensible). Il en résulte que le dispositif 100 électronique est notamment celui obtenu au cours du procédé de fabrication.

Le substrat 101 peut être une plaquette pour la formation de composants électroniques aussi appelé « wafer » dans le domaine technique de l'invention (ceci pouvant notamment être le cas dans le cadre du procédé de fabrication) ou une portion découpée de la plaquette dans le cadre du dispositif 100 électronique par exemple intégré à une puce électronique.

Il résulte de ce qui a été décrit ci-avant que la couche 103 de planarisation, suite à l'étape e) (et donc ce qu'il en reste après développement), est permanente dans le sens où elle est toujours présente dans le dispositif 100 électronique, bien entendu modifiée par rapport à son état à l'issue de l'étape c), notamment au cours des étapes d) et e). Ainsi, la portion de la couche 103 de planarisation destinée à être permanente au sein du dispositif 100 électronique fait partie de la couche 103 de planarisation dans son état « permanent » après l'étape e).

De préférence, afin de ne pas endommager le composant 102 électronique lors de la réalisation de l'étape e), le développeur est un produit inerte par rapport au composant 102 électronique. L'utilisation d'un tel produit inerte permet d'éviter à devoir se soucier d'un contrôle important comme c'est le cas pour une étape de gravure qui pourrait endommager le composant 102 électronique. Dans le cas où la couche 103 de planarisation protège le substrat 101 lors de l'étape e) (cas où la région 105a, 105b, 105c sacrificielle correspondante n'est pas en contact avec le substrat 101 mais seulement avec le composant 102 électronique), il peut être suffisant que le développeur soit un produit inerte par rapport au composant 102 électronique. De préférence, le développeur est un produit aussi inerte par rapport au substrat 101, cela permet d'éviter l'endommagement du substrat 101 si le développeur vient au contact de ce dernier, notamment lorsque la région 105a, 105b, 105c sacrificielle correspondante est au contact du composant 102 électronique et du substrat 101.

La résine peut comprendre un composé issu de la famille des siloxanes, comme par exemple un cyclopentanone, et le développeur peut être un alcool isopropylique.

Par exemple, la résine peut être un SINR du fabricant ShinEtsu. Une telle résine est une résine négative.

Dans le cas du SINR, l'étape d) peut être mise en œuvre à l'aide d'un rayonnement ultraviolet, et avant l'étape e) un recuit de la couche 103 de planarisation peut être réalisé.

Alternativement, la résine peut comprendre un HSQ (abréviation pour hydrogène silsesquioxane) et être une résine négative sensible au rayonnement ultraviolet extrême. Dans ce cas le développeur peut être à base de TMAH (abréviation de « tetramethylammonium hydroxide » en langue anglaise et correspondant à « tétraméthyl ammonium hydroxyde »).

La résine peut aussi être un SIPR, aussi produit par le fabricant ShinEtsu, qui est une résine positive qui se développe cependant au TMAH qui est une base et pas un solvant ; cela revient alors à faire une gravure d'une résine qui ne contient pas du BCB, ce qui est meilleur pour des raisons de santé mais qui n'est pas inerte pour le composant 102 électronique et le substrat 101.

Un avantage majeur du SINR est que son développeur est l'alcool isopropylique, qui est inerte aux surfaces rencontrées en microélectronique au contraire du TMAH qui peut graver certains matériaux.

De manière générale, et afin d'obtenir une surface plane à l'opposé du substrat 101, l'étape c) peut être mise en œuvre par un dépôt à la tournette. Cela permet d'éviter de recourir à un procédé de polissage mécano-chimique qui augmente généralement les coûts de production car il induit la mise en œuvre d'une étape supplémentaire.

De préférence, l'étape e) est telle que le fond du trou 107a, 107b, 107c est relié à une ouverture 112 du trou 107a, 107b, 107c (notamment agencée au niveau de la face 110 de la couche 103 de planarisation) par au moins un flanc 113 sortant du trou (figure 5), et de préférence par des flancs sortants. Cela permet de faciliter le dépôt du matériau M1 électriquement conducteur sur le ou les flancs/parois du trou 107a, 107b, 107c en vue de former un trou d'interconnexion de bonne qualité.

Par flanc(s) sortant(s), il est entendu que le flanc concerné diverge depuis le fond du trou 107a, 107b, 107c par rapport à un axe du trou 107a, 107b, 107c orthogonal au plan du substrat 101. Un flanc sortant est aussi appelé flanc avec pente positive.

Pour un même trou 107a, 107b, 107c, ce dernier peut comprendre un flanc de section circulaire augmentant plus l'on s'éloigne du substrat 101 ou plusieurs flancs sécants deux à deux s'étendant chacun depuis le fond du trou 107a, 107b, 107c.

Notamment, la présence du ou des flancs sortants est une conséquence d'une photolithographie (notamment des étapes d) et e)) adaptée qui permet d'obtenir naturellement (notamment pour le cas du SINR), ou en contrôlant de manière idoine l'insolation, une forme adaptée pour le dépôt continu d'une couche réalisée dans le matériau M1 électriquement conducteur entre le fond 107a, 107b, 107c du trou et la périphérie de son ouverture 112 du côté de la face 110 de la couche 103 de planarisation à l'opposé du substrat 101. Cela permet de limiter le taux de rebut lié à un problème de conduction électrique au niveau de la reprise de contact assurée par l'élément 108a, 108b, 108c électriquement conducteur.

L'élément 108a, 108b, 108c électriquement conducteur est notamment tel qu'il comprend une collerette 114 agencée sur la face 110 de la couche 103 de planarisation opposée au, et notamment distale du substrat 101. Bien que cela ne soit pas préféré, l'élément 108a, 108b, 108c électriquement conducteur peut combler le trou 107a, 107b, 107c correspondant.

De préférence, la partie 106a 106b, 106c du composant 102 électronique délimitant au moins en partie le fond du trou 107a, 107b, 107c est au moins en partie délimitée par une borne 111a, 111b, 111c de connexion du composant 102 électronique.

Comme par exemple montré sur la figure 5, la partie 106a 106b, 106c du composant 102 électronique délimite le fond du trou 107a, 107b, 107c et est délimitée par la borne 111a, 111b, 111c de connexion du composant 102 électronique.

Cette borne 111a, 111b, 111c de connexion peut être en métal. Par exemple, dans le cas où le composant 102 électronique est un laser, la borne de connexion peut comprendre ou être constituée par un empilement de trois couches comprenant successivement, depuis une partie correspondante du composant 102 électronique, une couche de nickel, une couche de germanium et une couche d'or, ou comprenant successivement, depuis une partie correspondante du composant 102 électronique, une couche de titane, une couche de platine et une couche d'or.

La borne 111a, 111b, 111c de connexion n'est pas obligatoire si l'élément 108a, 108b, 108c électriquement conducteur peut être déposé directement au contact d'une couche au sein du composant 102 électronique tout en permettant d'assurer sa fonction, notamment de reprise de contact.

Tout ce qui s'applique à l'élément 108a, 108b, 108c électriquement conducteur et au trou 107a, 107b, 107c peut s'appliquer à chacun de plusieurs éléments 108a, 108b, 108c électriquement conducteurs et de plusieurs trous 107a, 107b, 107c comme décrit ci-après.

Ainsi, le composant 102 électronique peut comprendre plusieurs éléments 108a, 108b, 108c électriquement conducteurs tels que décrit (par exemple au nombre de trois comme illustré en figure 6) afin de permettre une reprise de contacts sur le composant 102 électronique. A cet effet, et pour permettre de mutualiser la formation de ces éléments 108a, 108b, 108c électriquement conducteurs, l'étape d) peut être telle que le masque 104 de photolithographie permet de former plusieurs régions 105a, 105b, 105c sacrificielles (chacune telle que décrite ci-avant) au sein de la couche 103 de planarisation. Notamment, il est formé autant de régions 105a, 105b, 105c sacrificielles que d'éléments 108a, 108b, 108c électriquement conducteurs. Dès lors, chacune des régions 105a, 105b, 105c sacrificielles est en contact avec une partie 106a, 106b, 106c correspondante du composant 102 électronique et est apte à être retirée par le développeur. Ainsi, l'étape e) est telle que les régions 105a, 105b, 105c sacrificielles sont retirées toutes au moins en partie simultanément (cela dépendant bien entendu de la morphologie des régions sacrificielles entre elles, le retrait de l'une pouvant se terminer avant le retrait de l'autre). En fait, les régions 105a, 105b, 105c sacrificielles sont retirées de sorte à former une pluralité de trous 107a, 107b, 107c (trois dans l'exemple illustré en figure 5) présentant/comprenant chacun un fond délimité au moins en partie par la partie 106a, 106b, 106c correspondante du composant 102 électronique, et de préférence délimité par la partie 106a, 106b, 106c correspondante du composant 102 électronique qui peut être une borne 111a, 111b, 111c de connexion de ce dernier comme décrit ci-avant. L'étape f) est telle que le dépôt du matériau M1 électriquement conducteur permet de former les éléments 108a, 108b, 108c électriquement conducteurs au niveau de chacun des trous 107a, 107b, 107c.

L'utilisation de la résine photosensible pour former la couche 103 de planarisation qui sera ouverte localement par le développeur, (par exemple en plongeant l'ensemble visible en figure 4, après retrait du masque 104 de photolithographie, dans un liquide formant le développeur) en vue de déposer ensuite le matériau M1 électriquement conducteur sur la couche 103 de planarisation après l'étape e), permet une ouverture simultanée en différentes localisations à la face 110 de la couche 103 de planarisation et, le cas échéant, à différentes profondeurs d'une manière simple à industrialiser.

Les éléments 108a, 108b, 108c électriquement conducteurs sont notamment isolés électriquement les uns des autres soit au terme de l'étape f) en cas de dépôt localisé, soit par gravure du matériau M1 électriquement conducteur déposé.

De manière générale, le matériau M1 électriquement conducteur peut être un métal par exemple choisi parmi l'or et l'aluminium.

Ainsi, le dispositif 100 électronique peut comprendre plusieurs éléments 108a, 108b, 108c électriquement conducteurs chacun tel que décrit et en contact avec une partie 106a, 106b, 106c correspondante du composant 102 électronique et présentant/comprenant chacun une surface 109a, 109b, 109c de contact agencée du côté de la face 110 de la couche 103 de planarisation opposée au substrat 101. Grâce à cela, il est possible de former des liens électriques reliant le composant 102 électronique au travers de la couche 103 de planarisation, par exemple pour connecter un composant électronique additionnel au composant 102 électronique comprenant la couche 103 de planarisation, par exemple par la technique de report (« flip-chip »).

Il est compris de ce qui a été décrit ci-dessus que les éléments 108a, 108b, 108c électriquement conducteurs peuvent être reliés électriquement, notamment par contact direct à des bornes 111a, 111b, 111c de connexion du composant 102 électronique, notamment de manière individualisée. A cet effet, le composant 102 électronique formé à l'étape b) comprend les bornes 111a, 111b, 111c de connexion, par exemple au nombre de trois, et chacune des parties 106a, 106b, 106c correspondantes du composant 102 électronique est formée au moins en partie (et de préférence en intégralité) par une surface d'une des bornes 111a, 111b, 111c de connexion.

De préférence, au moins deux des bornes 111a, 111b, 111c de connexion sont de compositions différentes et/ou agencées à des hauteurs différentes par rapport au substrat 101. Ici il est alors compris un intérêt d'utiliser la résine au sein de la couche 103 de planarisation : elle peut être ouverte de manière simple et simultanée sans se préoccuper de temps de gravure ou de sélectivité d'arrêt de gravure.

Par « compositions différentes », il est entendu, par exemple, que lesdites au moins deux bornes de connexion de compositions différentes comprennent chacune au moins un matériau différent d'un matériau de l'autre desdites au moins deux bornes de connexion de compositions différentes. Par exemple, il a été décrit ci-avant deux empilements de trois couches, ces deux empilements de trois couches sont de compositions différentes et peuvent chacun être choisi pour former l'une desdites au moins deux des bornes 111a, 111b, 111c de connexion de compositions différentes.

Ainsi, dans le cadre du dispositif 100 électronique, le composant 102 électronique peut comprendre les bornes 111a, 111b, 111c de connexion et chacune des parties 106a, 106b, 106c correspondantes du composant 102 électronique est formée au moins en partie par une surface d'une des bornes 111a, 111b, 111c de connexion, au moins deux des bornes 111a, 111b, 111c de connexion étant de compositions différentes et/ou agencées à des hauteurs différentes par rapport au substrat 101.

Selon un mode de réalisation préféré, le composant 102 électronique est un composant optoélectronique, de préférence un laser. Une résine est tout particulièrement adaptée pour former une couche 103 de planarisation et d'encapsulation d'un composant optoélectronique. En effet, du fait de sa photosensibilité, elle est adaptée du point de vue caractéristiques optiques à ne pas entraver le fonctionnement du composant optoélectronique.

Il est à présent décrit un exemple particulier de réalisation d'un laser en tant que composant 102 électronique. Selon cet exemple particulier, le substrat 101 peut être en silicium ou en matériau III-V, il sert alors de support au composant 102 électronique qui comprend (figure 2) :
- une base 115 en InP dopé N agencée sur le substrat 101 ;
- une couche 116 quantique, aussi appelée zone active, destinée à former une cavité Fabry-Pérot du laser et agencée sur la base 115 notamment sur un sommet d'un corps de la base 115 s'étendant depuis une embase de la base ;
- une couche 117 en InP dopé P formée sur la couche 116 quantique formant un ruban dit « ruban III-V ».
Le composant 102 électronique comprend deux bornes 111a, 111c de connexion comprenant chacune un empilement successif d'une couche de nickel, d'une couche de germanium et d'une couche d'or formé sur la base 115 de sorte que la couche de nickel soit au contact de la base 115 (notamment de part et d'autre de son corps), formant des contacts métalliques au niveau du substrat 101. Le composant 102 électronique comprend en outre une borne 111b de connexion comprenant un empilement successif d'une couche de titane, d'une couche de platine et d'une couche d'or au sommet de la couche en InP dopé P à l'opposé du substrat 101 formant un contact ruban (la couche de titane étant alors au contact dudit sommet). Il en résulte que, outre l'utilisation possible de compositions différentes pour former les bornes 111a, 111c de connexion et la borne 111b de connexion, les bornes 111a, 111c de connexion et la borne 111b de connexion ne sont pas à un même niveau au-dessus du substrat 101.

Le procédé de fabrication décrit est tout particulièrement adapté à un tel laser dans le sens où la couche 103 de planarisation photosensible peut être ouverte simultanément à différents niveaux de topographie. Le SINR est préférentiellement utilisé ici en tant que résine photosensible car il présente des caractéristiques optiques compatibles pour recouvrir le laser. La couche 103 de planarisation permet une reprise de contacts à un même niveau et, le cas échéant, permet de connecter électriquement le dispositif électronique à une puce électronique par technique de report.

Bien entendu, l'invention ne se limite pas à un laser en tant que composant 102 électronique, tout autre type de composant électronique, par exemple des diodes électroluminescentes, présentant notamment une forte topographie nécessitant une planarisation avec reprise de contact peut être utilisé dans le cadre de la présente invention.

La présente invention trouve une application industrielle dans le domaine de la fabrication des composants électroniques, notamment dans le domaine de la microélectronique.

## Revendications

1. Procédé de fabrication d'un dispositif (100) électronique comprenant les étapes suivantes :
a) prévoir un substrat (101) ;
b) former un composant (102) électronique à partir du substrat (101) ;
c) former une couche (103) de planarisation en résine sur le composant (102) électronique, ladite résine étant photosensible et électriquement isolante ;
d) réaliser une insolation de la couche (103) de planarisation au travers d'un masque (104) de photolithographie d'où il résulte une délimitation d'une région (105a, 105b, 105c) sacrificielle au sein de la couche (103) de planarisation, ladite région (105a, 105b, 105c) sacrificielle étant en contact avec une partie (106a, 106b, 106c) du composant (102) électronique et étant apte à être retirée par un développeur ;
e) réaliser un développement à l'aide du développeur afin de retirer ladite région (105a, 105b, 105c) sacrificielle d'où il résulte l'obtention d'un trou (107a, 107b, 107c) présentant un fond délimité au moins en partie par ladite partie (106a, 106b, 106c) du composant (102) électronique ;
f) déposer un matériau (M1) électriquement conducteur pour obtenir un élément (108a, 108b, 108c) électriquement conducteur au niveau du trou (107a, 107b, 107c), ledit élément (108a, 108b, 108c) électriquement conducteur étant en contact avec le fond du trou (107a, 107b, 107c) et avec une portion de la couche (103) de planarisation destinée à être permanente au sein du dispositif (100) électronique, ledit élément (108a, 108b, 108c) électriquement conducteur présentant une surface (109a, 109b, 109c) de contact agencée du côté d'une face (110) de la couche (103) de planarisation opposée au substrat (101) ;
et dans lequel :
• l'étape d) est telle que le masque (104) de photolithographie permet de former plusieurs régions (105a, 105b, 105c) sacrificielles au sein de la couche (103) de planarisation, chacune des régions (105a, 105b, 105c) sacrificielles étant en contact avec une partie (106a, 106b, 106c) correspondante du composant (102) électronique et étant apte à être retirée par le développeur ;
• l'étape e) est telle que les régions (105a, 105b, 105c) sacrificielles sont retirées toutes au moins en partie simultanément, les régions (105a, 105b, 105c) sacrificielles étant retirées de sorte à former une pluralité de trous (107a, 107b, 107c) présentant chacun un fond délimité au moins en partie par la partie (106a, 106b, 106c) correspondante du composant (102) électronique ;
• l'étape f) est telle que le dépôt de matériau (M1) électriquement conducteur est réalisé pour former des éléments (108a, 108b, 108c) électriquement conducteurs au niveau de chacun des trous (107a, 107b, 107c) ;
**caractérisé en ce que** le composant (102) électronique formé à l'étape b) comprend des bornes (111a, 111b, 111c) de connexion, et **en ce que** chacune des parties (106a, 106b, 106c) correspondantes du composant (102) électronique est formée au moins en partie par une surface d'une des bornes (111a, 111b, 111c) de connexion, au moins deux des bornes (111a, 111b, 111c) de connexion étant agencées à des hauteurs différentes par rapport au substrat (101).

2. Procédé de fabrication selon la revendication 1, dans lequel le développeur est un produit inerte par rapport au composant (102) électronique et préférentiellement par rapport au substrat (101).

3. Procédé de fabrication selon l'une quelconque des revendications 1 à 2, dans lequel la résine comprend composé issu de la famille des siloxanes, comme par exemple un cyclopentanone, et dans lequel le développeur est un alcool isopropylique.

4. Procédé de fabrication selon l'une quelconque des revendications 1 à 3, dans lequel l'étape c) est mise en œuvre par un dépôt à la tournette.

5. Procédé de fabrication selon l'une quelconque des revendications 1 à 4, dans lequel l'étape e) est telle que le fond de chaque trou (107a, 107b, 107c) est relié à une ouverture (112) dudit trou (107a, 107b, 107c) par au moins un flanc (113) sortant dudit trou (107a, 107b, 107c).

6. Procédé de fabrication selon l'une quelconque des revendications 1 à 5, dans lequel lesdites au moins deux des bornes (111a, 111b, 111c) de connexion sont de compositions différentes.

7. Procédé de fabrication selon l'une quelconque des revendications 1 à 6, dans lequel le composant (102) électronique est un composant optoélectronique, de préférence un laser.

8. Dispositif (100) électronique comprenant :
• un substrat (101) ;
• un composant (102) électronique formé à partir du substrat (101) ;
• une couche (103) de planarisation permanente issue d'une résine photosensible et agencée au contact du composant (102) électronique ;
• plusieurs élément (108a, 108b, 108c) électriquement conducteurs traversant la couche (103) de planarisation, chacun en contact avec une partie (106a, 106b, 106c) correspondante du composant (102) électronique et présentant chacun une surface (109a, 109b, 109c) de contact agencée du côté d'une face (110) de la couche (103) de planarisation opposée au substrat (101);
**caractérisé en ce que** le composant (102) électronique comprend des bornes (111a, 111b, 111c) de connexion et **en ce que** chacune des parties correspondantes du composant (102) électronique est formée au moins en partie par une surface d'une des bornes (111a, 111b, 111c) de connexion, au moins deux des bornes (111a, 111b, 111c) de connexion étant agencées à des hauteurs différentes par rapport au substrat (101).

9. Dispositif (100) électronique selon la revendication 8, dans lequel lesdites au moins deux des bornes (111a, 111b, 111c) de connexion sont de compositions différentes.
